# EUROPEAN PATENT SPECIFICATION

(11) **EP 0 568 897 B1**
(45) Date of publication and mention of the grant of the patent: **17.07.1996**
(21) Application number: 93106766.4
(22) Date of filing: 27.04.1993
(51) Int. Cl.: H01S 3/06, H01S 3/094

(54) **Fiber optic amplifier with feedback insensitive pump laser**
Faseroptischer Verstärker mit rückwirkungsunempfindlichem Pumplaser
Amplificateur à fibre optique avec laser de pompage insensible à la rétroaction

(30) Priority: 04.05.1992 DE 4214766
(43) Date of publication of application: 10.11.1993
(73) Proprietor: Alcatel SEL Aktiengesellschaft, D-70435 Stuttgart (DE)
(72) Inventor: Heidemann, Rolf, Dr., W-7146 Tamm (DE); Otterbach, Jürgen, W-7250 Leonberg (DE)
(74) Representative: Pohl, Herbert, Dipl.-Ing

(56) References cited:
- ELECTRONICS LETTERS. Bd. 25, Nr. 7, 30. M rz 1989, STEVENAGE GB Seiten 455 - 456 R.I. LAMING ET AL. 'Multichannel crosstalk and pump noise characterisation of Er3+ doped fibre amplifier pumped at 980 nm.'
- PATENT ABSTRACTS OF JAPAN vol. 16, no. 139 (P-1334)8. April 1992 & JP-A-04 000 418

## Description

Die Erfindung betrifft einen faseroptischen Verstärker nach dem Oberbegriff des Patentanspruchs 1.

Ein faseroptischer Verstärker mit den dort genannten Merkmalen ist bekannt aus M. Shimizu et al: "Compact and Highly Efficient Fiber Amplifier Modules Pumped by a 0,98-µm Laser Diode", Journal of Lightwave Technology, Vol. 9, No. 2, February 1991, Seiten 291 bis 295. Die in dem Lichtsignale verstärkenden Faserstück enthaltende laseraktive Substanz ist dort Erbium, genauer gesagt Er³⁺-Ionen. Als Pumplaser dient ein Halbleiterlaser, auch Laserdiode genannt. Er emittiert Licht mit einer Wellenlänge von 980 nm. Dieses Licht, Pumplicht genannt, wird über einen faseroptischen Koppler in das Er³⁺-dotierte Faserstück eingespeist. Angesteuert wird der Pumplaser von einem Gleichstrom als Betriebsstrom.

Bei einer solchen Ansteuerung des Pumplasers besteht folgendes Problem: Der durch den Gleichstrom angesteuerte Halbleiterlaser ist im allgemeinen monomodig, d.h. er emittiert Licht mit einer einzigen Wellenlänge, z.B. 980 nm, oder er emittiert in nur wenigen Moden, d.h. er emittiert Licht mit mehreren Wellenlängen, z.B. drei Wellenlängen von 978 nm, 980 nm und 982 nm. In solchen Betriebsweisen ist ein Halbleiterlaser empfindlich gegen Rückreflexionen des Pumplichts. Solche Rückreflexionen des vom Pumplaser erzeugten Pumplichts können an allen Stellen im Ausbreitungsweg an denen Brechungsindexsprünge vorhanden sind, z.B. im Bereich des faseroptischen Kopplers oder an den Enden des Erbium-dotierten Faserstücks, oder an einem nachfolgenden Isolator auftreten. Dadurch ändert sich der Wirkungsgrad des Halbleiterlasers; das zurückreflektierte Pumplicht kann Schwankungen in der Intensität des vom Halbleiterlaser emittierten Pumplichts verursachen, weil die laseraktive Schicht des Halbleiterlasers zusammen mit einem Teil der Übertragungsstrecke (d.h. bis zu der Stelle mit dem Brechungsindexsprung) als Laserresonator wirkt. Dadurch ändert sich einerseits die Wellenlänge des vom Pumplaser emittierten Pumplichts, andererseits wird die Intensität des Pumplichts Oszillationen unterworfen. Besonders, wenn die Oszillationen im niederfrequenten Bereich, z.B. im Hertz- oder Kilohertz-Bereich, auftreten, wird die verstärkende Wirkung des Faserstücks zeitweise aufgehoben: Die optische Übertragung ist unter Umständen sogar unterbrochen.

Im Falle, daß zwei Pumplaser (jeweils Halbleiterlaser) vorhanden sind (bekannt aus K. Nakagawa et al: "Trunk and Distribution Network Application of Erbium-Doped Fiber Amplifier", Journal of Lightwave Technology, Vol. 9, No. 2, February 1991, Seiten 198 bis 208, insbesondere aus Fig. 3c auf S. 199), besteht das geschilderte Problem für jeden der beiden. Weiterhin besteht in diesem Falle das Problem, daß von jedem Pumplaser Restpumplicht in den jeweils anderen, gegenüberliegenden Pumplaser gelangt, was optische Instabilitäten verursacht, die dann wieder zu den oben geschilderten Problemen der Verstärkungsschwankungen führen. Daher werden heute im allgemeinen optische Isolatoren vor den Pumplasern eingesetzt.
Für das vorstehend geschilderte Problem ist in der älteren, unter Artikel 54(3) EPÜ fallenden europäischen Patentanmeldung EP 92 906 005 als Lösung vorgeschlagen, den überlicherweise als Betriebsstrom verwendeten Gleichstrom durch einen Wechselstrom zu modulieren, wobei die Frequenz des Wechselstroms oberhalb einer durch die reziproke Lebensdauer desjenigen Energieniveaus der laseraktiven Substanz, durch dessen Entleerung die Lichtsignale verstärkt werden, bestimmten Frequenz liegt.

Es ist die Aufgabe der Erfindung, eine andere Lösung des Problems anzugeben, einen optischen Verstärker mit einem Pumplaser oder mit zwei Pumplasern zu schaffen, der eine störungsfreie Verstärkung der Lichtsignale gewährleistet.

Die Aufgabe wird wie im Patentanspruch 1 angegeben gelöst.

Gegenüber bekannten faseroptischen Verstärkern hat die Erfindung den Vorteil, daß sie den kostenaufwendigen Einbau optischer Isolatoren zwischen dem Pumplaser und dem faseroptischen Koppler zur Vermeidung von Rückreflexionen des Pumplichts in den Pumplaser überflüssig macht.

Daß der erfindungsgemäß angesteuerte Pumplaser die gewünschte Eigenschaft hat, das Pumplicht für das lichtverstärkende Faserstück mit konstanter Intensität bereitzustellen, erklärt sich wie folgt: Der überlagerte Rauschstrom bewirkt, daß der Betriebsstrom des Lasers sich ständig und unregelmäßig ändert, mit der Folge, daß die Verteilung der Energie des vom Pumplaser erzeugten Lichts auf verschiedene Moden sich ständig ändert und dabei eine Vielzahl (20 - 30 Moden) von Moden teils gleichzeitig, teils schnell wechselnd nacheinander, angeregt werden. In anderen Worten: Die sogenannte Modenverteilung des Lasers ändert sich ständig, so daß sich die Resonanzbedingungen für rückreflektiertes Licht ständig ändern. Die Eingangs geschilderten Beeinträchtigungen der Emisonswellenlänge und Intensität des Pumplichts aufgrund von rückreflektiertem Pumplicht sind dadurch sehr unwahrscheinlich, so daß die Rückwirkungsempfindlichkeit des Pumplasers und dadurch die Stabilität der im Faserstück erfolgenden Verstärkung der zu übertragenden Lichtsignale erheblich verbessert ist.

Allerdings ist durch die erfindungsgemäße Maßnahme die Intensität des Pumplichts, das von der im Faserstück 2 enthaltenden laseraktiven Substanz absorbiert wird, mit Rauschen behaftet. Damit dieses Rauschen nicht auf die Verstärkung der zu übertragenden Lichtsignale übergeht, ist erfindungsgemäß der dem Gleichstrom überlagerte Rauschstrom so gefiltert, daß seine spektralen Anteile Frequenzen haben, die oberhalb der reziproken Lebensdauer desjenigen angeregten Energieniveaus der laseraktiven Substanz liegen, das die Verstärkung der zu übertragenden Lichtsignale bewirkt. Auf diese Weise werden Schwankungen der Intensität des Pumplichts von der laseraktiven Substanz nicht "wahrgenommen".

Vorteilhafte Weiterbildungen sind den Unteransprüchen zu entnehmen.

Im folgenden wird die Erfindung anhand von Zeichnungen, die ein Ausführungsbeispiel zeigen, näher erläutert.

Es zeigen:
Fig. 1 einen erfindungsgemäßen optischen Verstärker mit einem einzigen Pumplaser und
Fig. 2 einen erfindungsgemäßen Verstärker mit zwei Pumplasern.

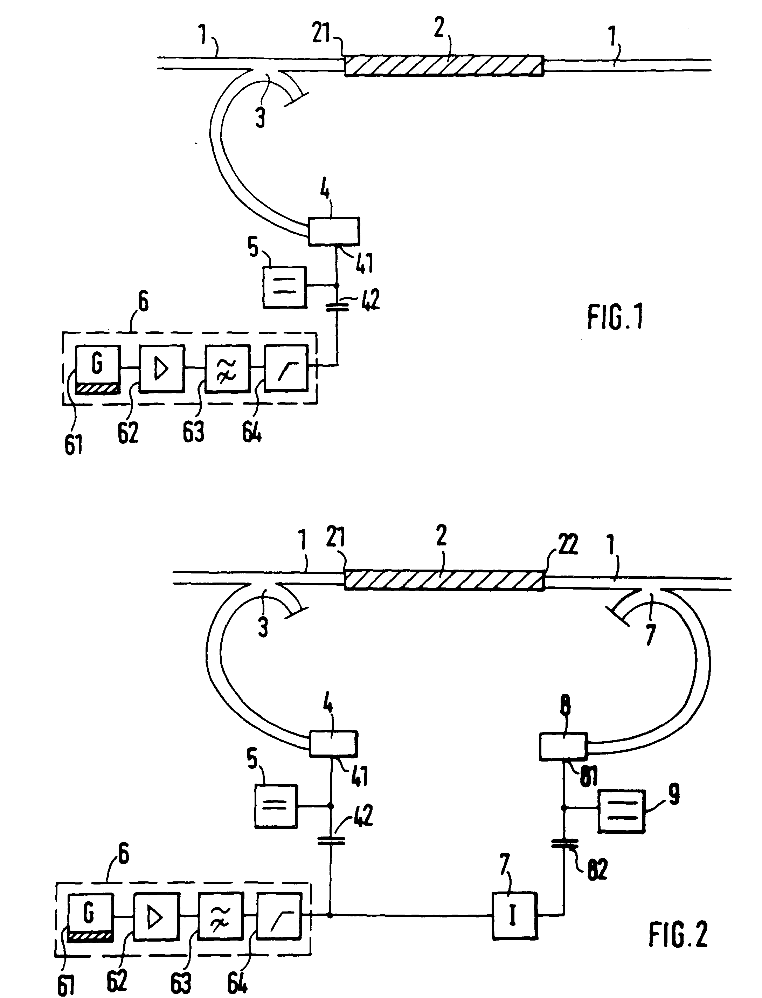

Bei Fig. 1 ist in eine Lichtwellenleiter-Übertragungsstrecke 1 ein faseroptischer Verstärker eingefügt. Typisch für ihn sind ein Faserstück 2, das mit einer laseraktiven Substanz, z.B. Erbium, dotiert ist, ein faseroptischer Koppler 3 und ein Pumplaser 4. Das Faserstück 2 ist an einem ersten Ende 21 über den faseroptischen Koppler an den Pumplaser 4 angekoppelt, so daß das vom Pumplaser 4 erzeugte Pumplicht in dieses Ende 21 des Faserstücks eingekoppelt wird. Der Pumplaser 4 ist ein Halbleiterlaser, beispielsweise ein InGaAsP/InP-, InGaAs/AlGaAs- oder GaAlAs/GaAs-Laser, der Licht im Wellenlängenbereich von 980 nm emittiert. Auf der Lichtwellenleiter-Übertragungsstrecke 1 werden Lichtsignale übertragen und in dem Faserstück 2 verstärkt. Die Lichtsignale haben beispielsweise eine Wellenlänge von 1550 nm. In welcher Richtung die Lichtsignale den Lichtwellenleiter 1 und das Faserstück 2 durchlaufen, spielt für die Erfindung keine Rolle. Über einen elektrischen Anschluß 41 ist der Pumplaser 4 mit einer Gleichstromquelle 5 verbunden. Soweit bisher beschrieben, stimmt der faseroptische Verstärker nach Fig. 1 mit den bekannten überein.

Erfindungsgemäß soll der Betriebsstrom des Pumplasers 4 kein Gleichstrom sondern ein Gleichstrom mit überlagertem Rauschstrom sein. Zu diesem Zweck ist bei der Gleichstromquelle 5 eine Rauschstromquelle 6 vorhanden, deren Ausgang über einen Koppelkondensator 42 an den Betriebsstrom-Eingang 41 des Pumplasers 4 angekoppelt ist. Somit fließt aus der Rauschstromquelle 6 über den Koppelkondensator ein Rauschstrom durch den Pumplaser 4, zusätzlich zu dem aus der Gleichstromquelle 5 fließenden Gleichstrom. In anderen Worten: Der Betriebsstrom des Pumplasers besteht aus einem Gleichstrom, dem ein Rauschstrom überlagert ist.

Wie der Rauschstrom sich auf die Verstärkung der Lichtsignale auswirkt, ist oben erläutert.

Einen großen Schaltungsaufwand bedeutet die erfindungsgemäß vorhandene Rauschstromquelle 6 nicht. Geeignet ist jede Rauschstromquelle, die an ihrem Ausgang einen Rauschstrom mit den erforderlichen Schwankungen erzeugt, wobei das Rauschspektrum frequenzmäßig oberhalb einer Mindestfrequenz liegt, die, wie oben erläutert, durch die Lebensdauer des für die Lichtverstärkung verantwortlichen Energieniveaus der laseraktiven Substanz im Faserstück 2 vorgegeben ist.

Diese Frequenz liegt praktisch bei etwa 1 MHz. Im folgenden wird ein Beispiel für eine geeignete Rauschstromquelle 6 erläutert. Wie Fig. 1 zeigt, sind ihre wesentlichen Komponenten ein Rauschgenerator 61, ein Verstärker 62, ein Hochpaßfilter 63 und ein Amplitudenbegrenzer 64. Der Rauschgenerator 61 kann beispielsweise durch eine Zenerdiode realisiert sein, deren Kathode über einen Widerstand an einer positiven Gleich-Vorspannung liegt und deren Anode auf Masse liegt, wie aus DE-C2 28 20 426 bekannt. Die an einer so betriebenen Zenerdiode bestehende Spannung ist stark mit Rauschen behaftet. Sie wird in den Verstärker 62 verstärkt, in dem Hochpaß 63 gefiltert, so daß sie nur noch Spektralanteile mit Frequenzen oberhalb der Grenzfrequenz von etwa 1 MHz enthält, und durchläuft dann den Amplitudenbegrenzer 64, der die Amplituden des Rauschstroms auf einen Maximalwert begrenzt und dadurch sicherstellt, daß durch den Laser 4 kein zu hoher Strom fließen kann, der ihn zerstören könnte.

Selbstverständlich sind vielerlei Ausgestaltungen der Rauschstromquelle 6 möglich. Fig. 1 zeigt nur die wesentlichen Funktionsmerkmale. Beispielsweise kann der Rauschgenerator 61 auch durch zwei Zenerdioden realisiert sein, deren Kathoden jeweils über einen Widerstand an einer positiven Gleich-Vorspannung liegen und deren Anoden auf Masse liegen. Die zwischen ihren beiden Kathoden bestehende Spannung ist dann auch stark mit Rauschen behaftet. Sie wird ebenfalls in einem Verstärker verstärkt, in einem Hochpaß gefiltert und durchläuft einen Amplitudenbegrenzer. Der Verstärker kann ein mehrstufiger Verstärker sein, und auch das Hochpaßfilter 63 kann aus mehreren Stufen bestehen. Z.B. können zur Hochpaß-Filterung Kondensatoren zwischen den einzelnen Verstärkerstufen und am Ausgang der letzten Verstärkerstufe vorhanden sein.

Da die Rauschstromquelle 6 eine Hochfrequenz-Vorrichtung ist, sollte sie wie jegliche Hochfrequenzvorrichtung gegenüber allen anderen elektrischen Teilen des Systems abgeschirmt sein. Gerade weil es sich um eine Quelle von Rauschen handelt, ist die Abschirmung allerdings kein besonders kritisches Problem. Sollte es vorkommen, daß trotz der Abschirmung Spektralanteile auf andere elektrischen Teile des Systems überkoppeln, so werden solche Spektralanteile keine großen Störungen der Signalübertragung verursachen, da sie, wie es für Rauschen typisch ist, eine kleine Leistungsdichte haben.

Ein für eine Rauschspannungsquelle typischer Vorteil ist, daß sie für Halbleiterleiser, die aufgrund von Exemplarstreuungen in ihrem Modenspektrum voneinander abweichen, gleichermaßen geeignet ist. Eine Anpassung an ein spezielles Exemplar eines Pumplasers eines bestimmten Typs ist also nicht erforderlich.

Wie oben erwähnt, besteht das eingangs geschilderte Problem der Rückwirkungsempfindlichkeit von Pumplasern im Falle von zwei Pumplasern, die Pumplicht in das verstärkende Faserstück 2 einspeisen, für jeden der beiden. Im allgemeinen ist für jeden der beiden Pumplaser eine eigene Gleichstromquelle vorhanden. Eine mögliche Lösung besteht dann einfach darin, daß bei jedem der beiden Pumplaser eine Rauschspannungsquelle vorhanden ist, aus der ein Rauschstrom in den jeweiligen Pumplaser fließt, der sich dem überlicherweise fließenden Gleichstrom überlagert. Es ist also für jeden der beiden Pumplaser eine Betriebsstromquelle vorhanden, wie sie in Fig. 1 für einen einzigen Pumplaser gezeigt ist. In diesem Fall sind die durch die beiden Pumplaser fließenden Rauschströme nicht miteinander korreliert, so daß auch die durch sie bewirkten Modenverteilungen der beiden Pumplaser nicht korreliert sind. Dadurch ist es hinreichend unwahrscheinlich, daß einer der beiden Pumplaser durch Pumplicht, das vom anderen Pumplaser zu ihm gelangt, in der Aussendung seines eingenen Pumplichts gestört werden kann.

Dies läßt sich auch dann erreichen, wenn, wie in Fig. 2 gezeigt beide Pumplaser einen Rauschstrom aus einer einzigen Rauschstromquelle 6 eingespeist bekommen und dabei dafür gesorgt ist, daß die eingespeisten Rauschströme sich voneinander unterscheiden. Dafür kann gesorgt werden, indem der in einen der beiden Pumplaser fließende Rauschstrom invertiert wird und der in den anderen Pumplaser fließende Rauschstrom nicht. In Fig. 2 ist dies durch einen Invertierer 7 angedeutet, über den der Rauschstrom von der Rauschstromquelle 6 in einen zweiten Pumplaser 8 fließt. Statt eines Invertierers kann auch irgendein Mittel vorgesehen sein, das den einen Rauschstrom gegenüber dem anderen in der Phase verändert, so daß sichergestellt ist, daß nicht beide Pumplaser exakt mit dem selben Rauschstrom betrieben werden. Man kann dies auch erreichen, indem man in der Rauschstromquelle einen Verstärker mit zwei komplementären Ausgängen verwendet und den einen Ausgang (über einen Hochpaß und einen Amplitudenbegrenzer) an den einen und den anderen Ausgang an den anderen Pumplaser anlegt.

Im übrigen gelten alle im Zusammenhang mit Fig. 1 gegebenen Erläuterüngen zur Rauschstromerzeugung auch für das Ausführungsbeispiel der Fig. 2. Das Ausführungsbeispiel nach Fig. 2 entspricht in seinem linken Teil genau dem nach Fig. 1, so daß dieser Teil nicht nochmals erläutert zu werden braucht. Das Faserstück 2 ist an einem zweiten Ende 22 über einen faseroptischen Koppler 7 an einen zweiten Pumplaser 8 angekoppelt. An dessen Betriebsstromeingang 81 ist der Ausgang einer Gleichstromquelle 9 angeschlossen und über einen Koppelkondensator 82 ist der Ausgang des obengenannten Inverters 7 oder eines nicht gezeigten Phasenschieber-Gliedes oder ein zweiter Ausgang der Rauschstromquelle 6 angeschlossen.

## Claims

1. A fiber-optic amplifier comprising a light-signal-amplifying section of fiber (2) which contains an active laser medium and is coupled to at least one semiconductor laser (4) which serves as a pump source and can be activated by an operating current from an operating-current source (5, 6), wherein the operating current is a direct current having a noise current superimposed thereon, and wherein the spectral components of the noise current have frequencies which lie above the reciprocal lifetime of that energy level of the active laser medium which causes the amplification of the light signals.

2. An amplifier as claimed in claim 1 wherein to generate the noise current, the operating-current source (5, 6) includes essentially a noise generator (61) and means for amplifying (62), high-pass-filtering (63), and limiting (64) the noise voltage generated.

3. An amplifier as claimed in claim 1 or 2 wherein, if two pump sources (4, 8) are coupled to the section of fiber (2), there are provided a single source (6) for generating the noise currents contained in the operating currents for the two pump sources (4, 8) and means (7) for generating two different noise currents from the output current of the source (6).

## Patentansprüche

1. Faseroptischer Verstärker mit einem Lichtsignale verstärkenden, eine laseraktive Substanz enthaltenden Faserstück (2), das an mindestens einen als Pumplichtquelle dienenden Halbleiterlaser (4) angekoppelt ist, der durch einen Betriebsstrom aktivierbar ist, den eine Betriebsstromquelle (5, 6) erzeugt, wobei der Betriebsstrom ein Gleichstrom mit überlagertem Rauschstrom ist, wobei die spektralen Anteile des Rauschstroms Frequenzen haben, die oberhalb der reziproken Lebensdauer des Energieniveaus der laseraktiven Substanz, das die Verstärkung der Lichtsignale bewirkt, liegen.

2. Verstärker nach Anspruch 1, wobei die Betriebsstromquelle (5, 6) zum Erzeugen des Rauschstroms im wesentlichen einen Rauschgenerator (61) sowie Mittel zum Verstärken (62), zum Hochpaß-Filtern (63) und zum Begrenzen (64) der erzeugten Rauschspannung enthält.

3. Verstärker nach Anspruch 1 oder 2, wobei im Falle von zwei an das Faserstück (2) angekoppelten Pumplichtquellen (4, 8) zum Erzeugen der in den Betriebsströmen der beiden Pumplichtquellen (4, 8) enthaltenen Rauschströme eine einzige Quelle (6) vorhanden ist und ferner Mittel (7) vorhanden sind, um aus dem Ausgangsstrom der Quelle (6) zwei unterschiedliche Rauschströme zu erzeugen.

## Revendications

1. Amplificateur à fibres optiques comportant une pièce de fibres (2) amplifiant les signaux lumineux et contenant une substance active dans un laser, couplée à au moins à un laser à semiconducteur (4) servant de source de lumière de pompage, lequel peut être activé par un courant de service générant une source de courant de service (5, 6), le courant de service étant un courant continu comportant un courant de bruit superposé, les parties spectrales du courant de bruit ayant des fréquences situées au-dessus de la durée de vie réciproque du niveau d'énergie de la substance active dans un laser qui produit l'amplification des signaux lumineux.

2. Amplificateur selon la revendication 1, la source de courant de service (5, 6) comportant essentiellement pour la génération du courant de bruit un générateur de bruit (61) ainsi que des moyens pour l'amplification (62), pour le fitrage passe-haut (63) et pour la limitation (64) de la tension de bruit générée.

3. Amplificateur selon la revendication 1 ou 2, sur lequel, dans le cas de deux sources lumineuses de pompage (4, 8) couplées à la pièce de fibres (2) pour la génération des courants de bruit contenus dans les courants de service des deux sources de lumière de pompage (4, 8), on dipose d'une seule source (6) et sur lequel on dispose en outre de moyens (7) destinés à générer à partir du courant de sortie de la source (6) deux courants de bruit différents.
